# EUROPÄISCHE PATENTANMELDUNG

(11) **EP 1 193 737 A1**
(43) Veröffentlichungstag der Anmeldung: **03.04.2002**
(21) Anmeldenummer: 01121469.9
(22) Anmeldetag: 07.09.2001
(51) Int. Cl.: H01L 21/00, B65D 25/10

(54) **Verfahren zum Transport von Wafern**

(30) Priorität: 21.09.2000 DE 10046942
(71) Anmelder: Infineon Technologies AG, 81669 München (DE)
(72) Erfinder: Kanduth, Karl-Heinz, 9500 Villach (AT)
(74) Vertreter: Kindermann, Peter, Dipl.-Ing.

(57) **Zusammenfassung**

Die Erfindung betrifft ein Verfahren zum Transport von als 200 mm - Wafern ausgebildeten Wafern (1) mittels erster Behälter mit einer Kapazität zur Lagerung eines Loses von 25 Wafern (1), wobei jeder Wafer (1) einzeln in einem Einschub vorgegebener Breite gelagert ist. Zur Aufnahme von verbogenen Wafern (1) sind zweite Behälter mit einer Kapazität zur Lagerung eines Loses von 13 Wafern (1) vorgesehen, wobei die Breiten der Einschübe gegenüber den Breiten der Einschübe des ersten Behälters bei gleichen Außenabmessungen beider Behälter vergrößert sind.

## Beschreibung

Die Erfindung betrifft ein Verfahren zum Transport von Wafern gemäß dem Oberbegriff des Anspruchs 1 sowie einen Behälter zur Durchführung des Verfahrens gemäß dem Oberbegriff des Anspruchs 5.

Zur Herstellung von integrierten Schaltkreisen und dergleichen erfolgt in Halbleiterfertigungsanlagen eine mehrstufige Bearbeitung von Wafern. Die Wafer bestehen aus kreisförmigen Siliziumscheiben, wobei sich die vorliegende Erfindung auf 200 mm - Wafer bezieht, d.h. auf Siliziumscheiben mit Durchmessern von 200 mm.

Zur Herstellung der integrierten Schaltkreise werden an den Wafern verschiedene Bearbeitungsschritte durchgeführt, wobei hierfür unterschiedliche Fertigungseinrichtungen in einem Reinraum vorgesehen sind.

Die Wafer werden über ein Transportsystem den einzelnen Fertigungseinrichtungen in vorgegebenen Losgrößen zugeführt. Jedes Los umfasst 25 Wafer, die in einem Behälter, einer sogenannten Metallhorde, untergebracht sind. Ein derartiger Behälter weist entsprechend der Losgröße 25 Einschübe auf, in welchen die Wafer einzeln gelagert sind.

Die zu bearbeitenden Wafer weisen äußerst geringe Scheibendicken auf, die typischerweise in der Größenordnung von 150 um oder sogar darunter liegen.

Bei der Durchführung der einzelnen Bearbeitungsschritte, insbesondere bei einem Dünnschleifen der Wafer, treten daher regelmäßig Verbiegungen der Wafer auf. Problematisch hierbei ist, dass diese verbogenen Wafer nicht oder nur mit großem Aufwand nach einem Bearbeitungsschritt wieder in die Behälter eingebracht werden können. Insbesondere besteht dabei eine erhebliche Bruchgefahr für die Wafer. Durch ein derartiges Brechen sind die Wafer unbrauchbar. Dies bedeutet eine stark erhöhte Ausschussrate der Wafer und damit eine unerwünscht hohen Bedarf an Wafern, was die Fertigungskosten für die integrierten Schaltkreise erheblich erhöht.

Der Erfindung liegt die Aufgabe zugrunde eine möglichst effiziente Bearbeitung von Wafern zu gewährleisten.

Zur Lösung dieser Aufgabe sind die Merkmale der Ansprüche 1 und 5 vorgesehen. Vorteilhafte Ausführungsformen und zweckmäßige Weiterbildungen der Erfindung sind in den Unteransprüchen beschrieben.

Gemäß dem erfindungsgemäßen Verfahren sind zum Transport von als 200 mm - Wafern ausgebildeten Wafern erste Behälter vorgesehen. Diese Behälter weisen eine Kapazität zur Lagerung eines Loses von 25 Wafern auf. Dabei ist jeder Wafer einzeln in einem Einschub vorgegebener Breite gelagert. Zur Aufnahme von verbogenen Wafern sind zweite Behälter mit einer Kapazität zur Lagerung eines Loses von 13 Wafern vorgesehen, wobei die Breiten der Einschübe gegenüber den Breiten der Einschübe des ersten Behälters bei gleichen Außenabmessungen beider Behälter vergrößert sind.

Dabei sind erfindungsgemäß bei den zweiten Behältern die Breiten der Einschübe an die Durchbiegungen der Wafer angepasst.

Der Grundgedanke der Erfindung besteht somit darin, zum Transport der Wafer zwei verschiedene Behälter einzusetzen, wobei die ersten Behälter zum Transport von nicht verbogenen Wafern und die zweiten Behälter zum Transport von verbogenen Wafern dienen.

Wesentlich hierbei ist zum einen, dass die verbogenen Wafer in den zweiten Behältern sicher und ohne Gefahr von Beschädigungen gelagert werden können. Mit den zweiten Behältern wird somit ein automatisches Handling von verbogenen Wafern gewährleistet und gleichzeitig die Gefahr eines Brechens der Wafer vermieden.

Ein weiterer Vorteil des erfindungsgemäßen Verfahrens besteht darin, dass die ersten und zweiten Behälter dieselben Außenabmessungen aufweisen. Damit können die verschiedenen Behälter in identischer Weise über das Transportsystem den Fertigungseinrichtungen zugeführt werden. Insbesondere können Fördereinrichtungen wie Förderbänder und Handhabungseinrichtungen wie zum Beispiel Greifer, Roboter oder dergleichen, die zum Transport der ersten Behälter verwendet werden, in unveränderter Form auch für den Transport und die Handhabung der zweiten Behälter verwendet werden, so dass diesbezüglich durch die Einführung der zweiten Behälter keinerlei Zusatzanforderungen notwendig werden.

Gemäß einem weiteren vorteilhaften Aspekt der Erfindung ist eine Losgröße von 25 Wafern in einem ersten Behälter in zwei Teillose in den zweiten Behältern unterteilt, in welchen jeweils 13 Wafer eingelagert werden können. Durch die so ausgebildeten ersten und zweiten Behälter wird eine einfache und leicht zu überschauende Logistik bei der Führung der Wafer durch die Fertigungseinrichtungen erzielt. Solange die Wafer nicht verbogen sind werden diese in Losgrößen von 25 Stück in den ersten Transportbehältern transportiert. Sobald durch bestimmte Bearbeitungsschritte die Wafer verbogen werden, wird ein Los von 25 Wafern in zwei Teillose unterteilt, wobei jeweils ein Teillos von 12 bzw. 13 Wafern in einen zweiten Behälter umgeladen wird, ohne dass Restwafer verbleiben, die weiteren Losen zugeteilt werden müssen.

Prinzipiell ist es denkbar, dass in den zweiten Behältern auch nicht verbogene Wafer transportiert werden. In einer vorteilhaften Ausführungsform sind die Wafer auf die Behälter jedoch derart verteilt, dass in den ersten Behälter nur unverbogene Wafer und in dem zweiten Behälter nur verbogene Wafer gelagert werden.

In einer bevorzugten Ausführungsform der Erfindung sind die Einschübe zur Aufnahme der einzelnen Wafer bei den zweiten Behältern etwa doppelt so breit wie bei den ersten Behältern. Dies wird besonders einfach dadurch erreicht, dass die Anzahl der vorzugsweise äquidistant über die gesamte Breite der Behälter angeordneten, die Einschübe begrenzenden Stege entsprechend gewählt wird. Im Vergleich zu einem ersten Behälter ist bei dem zweiten Behälter jeder zweite Steg weggelassen, wodurch sich die doppelte Breite des entsprechenden Einschubs ergibt. Ansonsten sind die ersten und zweiten Behälter vorzugsweise baugleich.

Die Erfindung wird im nachstehenden anhand der Zeichnungen erläutert. Es zeigen:
- Figur 1:: Perspektivische Darstellung eines Ausführungsbeispiels des erfindungsgemäßen Behälters zum Transport von Wafern.
- Figur 2:: Längsschnitt durch den Behälter gemäß Figur 1.
- Figur 3:: Querschnitt durch den Behälter gemäß Figur 1.

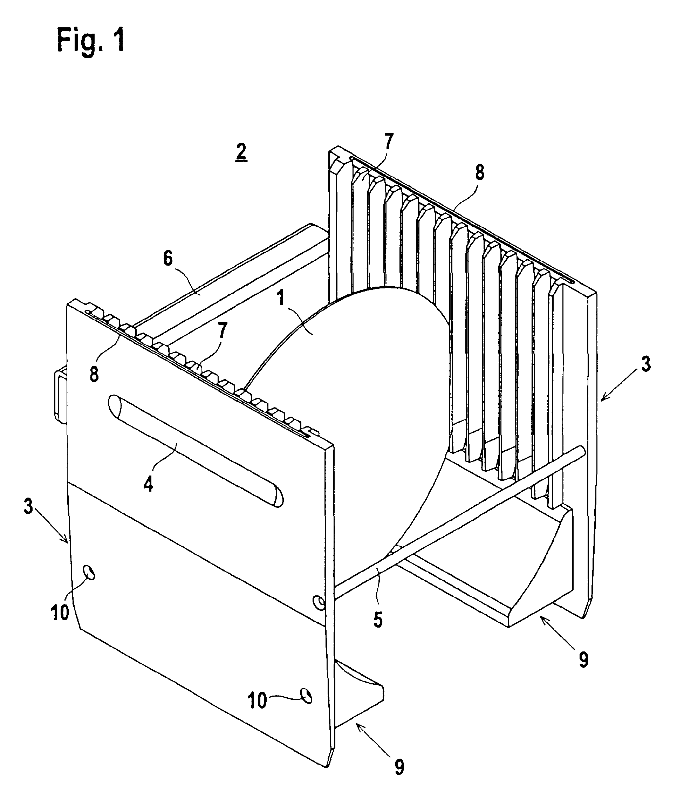

Figur 1 zeigt ein Ausführungsbeispiel des erfindungsgemäßen Behälters zum Transport von Wafern 1.

Der Behälter ist als Metallhorde 2 ausgebildet und dient zur Lagerung von als 200 mm - Wafer ausgebildeten Wafern 1, das heißt Halbleiterscheiben mit einem Durchmesser von 200 mm. Die Wafer 1 werden zur Herstellung von integrierten Schaltkreisen und dergleichen verwendet und werden hierzu in einer in einem Reinraum angeordneten Halbleiterfertigungsanlage über ein Transportsystem verschiedenen Fertigungseinrichtungen zur Durchführung unterschiedlicher Bearbeitungsschritte zugeführt.

Die Wafer 1 weisen äußerst dünne Scheibendicken auf, die in der Größenordnung von 150 µm und kleiner liegen. Bei bestimmten Bearbeitungsschritten wie beispielsweise dem Dünnschleifen der Wafer 1 werden diese unvermeidlich in gewissem Umfang verbogen. Die erfindungsgemäße Metallhorde 2 gemäß den Figuren 1 - 3 dient zur Lagerung derartiger verbogener Wafer 1.

Die Metallhorde 2 weist zwei im wesentlichen baugleiche Seitenteile 3 auf, welche zwei gegenüberliegende Seitenwände der Metallhorde 2 bilden. Die Seitenteile 3 bestehen vorzugsweise aus Aluminium und sind an ihren Oberflächen mit Teflon beschichtet.

Jedes Seitenteil 3 weist eine im wesentlichen ebene, rechtekkige Rückwand auf, welche die Außenseite einer Seitenwand der Metallhorde 2 bildet. Im oberen Bereich der Seitenwand ist eine Ausnehmung vorgesehen, die als Griff 4 für eine Bedienperson dient.

Die Seitenteile 3 sind an der Vorderseite der Metallhorde 2 über eine Distanzstange 5 verbunden, die vorzugsweise aus Nirosta besteht. An der Rückseite der Metallhorde 2 sind die Seitenteile 3 über ein Rückenblech 6 aus Aluminium verbunden. Das Rückenblech 6 weist einen im wesentlichen rechteckigen Querschnitt auf.

Die so ausgebildete Metallhorde 2 weist eine im wesentlichen quaderförmige Außenkontur auf. Die an der Distanzstange 5 und dem Rückenblech 6 fixierten Seitenteile 3 stehen sich mit parallel zueinander verlaufenden Frontseiten in Abstand gegenüber.

Der Abstand der Seitenteile 3 ist so gewählt, dass die Wafer 1 über die offene Oberseite der Metallhorde 2 eingeführt werden und dann in vertikaler Position in Abstand nebeneinander gelagert sind.

Dabei sind die Wafer 1 seitlich an Einschüben fixiert, deren Breiten an die Durchbiegungen der Wafer 1 angepasst sind, so dass bei Einführen der Wafer 1 in die Einschübe keine Gefahr von Beschädigungen, insbesondere eines Brechens der Wafer 1 besteht.

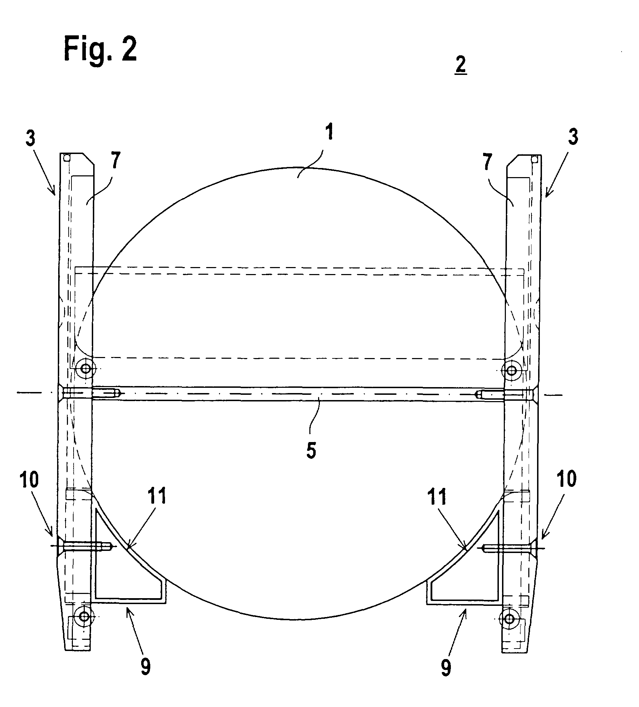

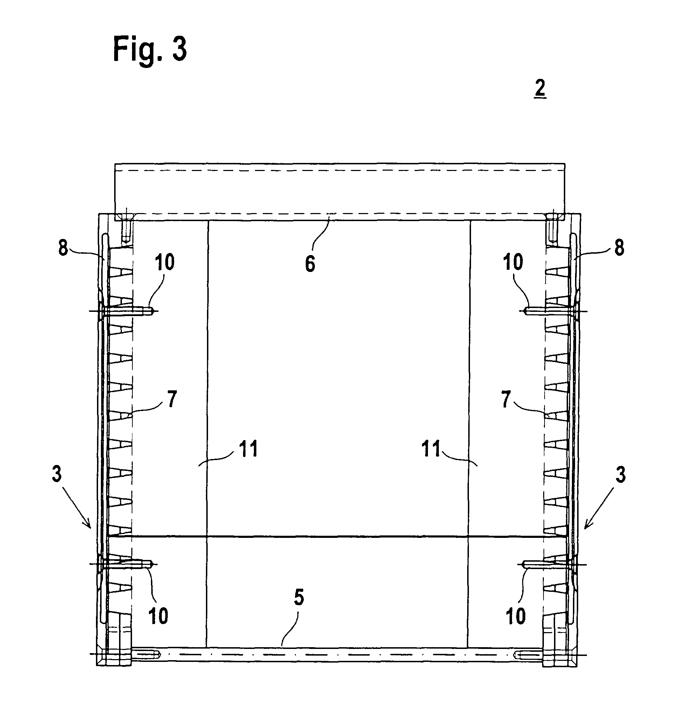

An der Innenseite jedes Seitenteils 3 sind vertikal verlaufende Stege 7 vorgesehen, die jeweils parallel zueinander verlaufen und vorzugsweise äquidistant zueinander angeordnet sind. Die Stege 7 stehen von der im wesentlichen ebenen Innenseite des Seitenteils 3 senkrecht hervor und weisen eine über deren Länge konstante Höhe auf (Figur 2). Der Querschnitt der Stege 7 ist über dessen Länge ebenfalls konstant. Wie aus Figur 3 ersichtlich ist der Querschnitt der Stege 7 im wesentlichen dreieckförmig und verjüngt sich kontinuierlich zum vorderen Ende des Steges 7 hin.

Die Stege 7 sind über die gesamte Breite des Seitenteils 3 gleichmäßig verteilt, wobei jeweils der erste und letzte Steg 7 von einem verbreiterten Wandelement gebildet ist, welches das Seitenteil 3 zum jeweiligen Rand hin begrenzt.

Die Stege 7 an den Seitenteilen 3 sind jeweils identisch ausgebildet, so dass sich paarweise jeweils ein Steg 7 des ersten Seitenteils 3 und ein Steg 7 des zweiten Seitenteils 3 gegenüberstehen.

Entsprechend stehen sich die Zwischenräume zwischen benachbarten Stegen 7 über die beiden Seitenteile 3 gegenüber. Jeweils ein Paar von Zwischenräumen bildet den Einschub für einen Wafer 1.

Da sich die Stege 7 zu ihren vorderen Enden hin verjüngen, ist im vorderen Bereich der Stege 7 der jeweilige Zwischenraum verbreitert, wodurch das Einführen der Wafer 1 in die Einschübe erleichtert wird.

Die Zwischenräume zwischen den Stegen 7 münden an den oberen Rändern der Seitenteile 3 aus, so dass ein Wafer 1 von der Oberseite der Metallhorde 2 in den jeweiligen Einschub eingesetzt werden kann. Damit beim Einführen des Wafers 1 Beschädigungen vermieden werden, ist an den oberen Rändern der Seitenteile 3 jeweils eine Stoßstange 8 aus Teflon vorgesehen. Die Stoßstangen 8 verlaufen jeweils über die gesamte Breite eines Seitenteils 3.

An die unteren Ränder der Stege 7 eines Seitenteils 3 schließt ein Stützteil 9 an. Das Stützteil 9 besteht vorzugsweise aus Teflon und ist mit seiner ebeneren Rückseite an der Innenseite des Seitenteils 3 mittels Schrauben 10 befestigt.

Die Stützteile 9 an beiden Seitenteilen 3 sind identisch ausgebildet und in gleicher Weise am jeweiligen Seitenteil 3 montiert, so dass diese in gleicher Höhe in Abstand gegenüberliegend angeordnet sind.

Jedes Stützteil 9 verläuft in seiner Längsrichtung über die gesamte Breite des jeweiligen Seitenteils 3 und weist einen über seine gesamte Länge konstanten Querschnitt auf. Die ebene Unterseite des Stützteils 9 verläuft in horizontaler Richtung. Ebenso verläuft die Oberkante des Stützteils 9 in horizontaler Richtung und schließt unmittelbar an die unteren Ränder der Stege 7 an.

Die in den Innenraum der Metallhorde 2 gerichtete Oberseite des Stützteils 9 weist eine Auflagefläche 11 auf, die an die Randkontur der Wafer 1 angepasst ist, so dass die Wafer 1 mit einem Teil ihres Randes bündig auf der Auflagefläche 11 aufliegen.

Die Auflagefläche 11 weist hierzu einen kreissegmentförmigen Querschnitt auf, wobei der Krümmungsradius des Kreissegments dem Radius des Wafers 1 entspricht.

Somit liegen sämtliche Wafer 1 in der Metallhorde 2 in gleicher Weise über die gesamten Längen über jeweils einen großen Winkelbereich bündig mit einem Teil ihrer Ränder auf den Auflageflächen 11 der Stützteile 9 auf. Dadurch ist ein sicherer Halt der Wafer 1 gewährleistet, wobei insbesondere auch für verbogene Wafer 1 eine Auflagefläche 11 bereitgestellt wird, welche den Wafer 1 gegen Beschädigungen sichert. Dieser Effekt wird dadurch verstärkt, dass die Auflagefläche 11 unprofiliert ist. Die glatte Auflagefläche 11 verhindert ein Verkanten der Wafer 1 bei Einführen in die Einschübe.

Erfindungsgemäß ist die Anzahl der über die Breite des Seitenteils 3 verteilten Stege 7 so gewählt, dass insgesamt 13 Einschübe gleicher Breite zur Aufnahme von verbogenen Wafern 1 entstehen.

Zweckmäßigerweise werden in derartigen Behältern nur verbogene Wafer 1 gelagert.

Zudem werden in der Halbleiterfertigungsanlage weitere Behälter eingesetzt, die im wesentlichen baugleich mit den Metallhorden 2 gemäß den Figuren 1 - 3 sind. Als einziger Unterschied zu den Behältern gemäß den Figuren 1 - 3 weisen diese Behälter die doppelte Anzahl von Stegen 7 auf, so dass die Anzahl der Einschübe anstelle von 13 nun 25 beträgt. Entsprechend sind die Breiten der Einschübe um die Hälfte reduziert. Diese Behälter werden zur Lagerung von nicht verbogenen Wafern 1 verwendet.

### Bezugszeichen

- (1): Wafer
- (2): Metallhorde
- (3): Seitenteil
- (4): Griff
- (5): Distanzstange
- (6): Rückenblech
- (7): Steg
- (8): Stoßstange
- (9): Stützteil
- (10): Schrauben
- (11): Auflagefläche

## Patentansprüche

1. Verfahren zum Transport von als 200 mm - Wafern ausgebildeten Wafern mittels erster Behälter mit einer Kapazität zur Lagerung eines Loses von 25 Wafern, wobei jeder Wafer einzeln in einem Einschub vorgegebener Breite gelagert ist, **dadurch gekennzeichnet, dass** zur Aufnahme von verbogenen Wafern (1) zweite Behälter mit einer Kapazität zur Lagerung eines Loses von 13 Wafern (1) vorgesehen sind, wobei die Breiten der Einschübe gegenüber den Breiten der Einschübe des ersten Behälters bei gleichen Außenabmessungen beider Behälter vergrößert sind.

2. Verfahren nach Anspruch 1, **dadurch gekennzeichnet, dass** in den ersten Behältern ausschließlich nicht verbogene Wafer (1) und in den zweiten Behältern ausschließlich verbogene Wafer (1) gelagert werden.

3. Verfahren nach einem der Ansprüche 1 oder 2, **dadurch gekennzeichnet, dass** die Breiten der Einschübe der zweiten Behälter doppelt so groß wie die Breiten der Einschübe der ersten Behälter sind.

4. Verfahren nach Anspruch 3, **dadurch gekennzeichnet, dass** die Einschübe von an gegenüberliegenden Seitenwänden der Behälter äquidistant angeordneten Stegen (7) seitlich begrenzt werden, wobei gegenüber der Anordnung der Stege (7) des ersten Behälters bei dem zweiten Behälter jeweils jeder zweite Steg (7) weggelassen wird.

5. Behälter zur Aufnahme von als 200 mm - Wafer ausgebildeten Wafern, insbesondere zur Durchführung des Verfahrens nach einem der Ansprüche 1 - 4, **dadurch gekennzeichnet, dass** dieser Einschübe zur Aufnahme eines Loses von 13 verbogenen Wafern (1) aufweist, wobei die Breiten der Einschübe an die Durchbiegungen der Wafer (1) angepasst sind.

6. Behälter nach Anspruch 5, **dadurch gekennzeichnet, dass** dieser zwei gegenüberliegend angeordnete Seitenteile (3) aufweist, von deren Innenseiten vertikal verlaufende, in Abstand zueinander angeordnete Stege (7) hervorstehen, wobei jeweils ein Steg (7) an einem Seitenteil (3) einem entsprechenden Steg (7) am zweiten Seitenteil (3) gegenüberliegt, und dass ein Einschub zur Lagerung eines Wafers (1) von einem Zwischenraum zwischen benachbarten Stegen (7) eines Seitenteils (3) und des gegenüberliegenden Zwischenraums am anderen Seitenteil (3) gebildet ist.

7. Behälter nach Anspruch 6, **dadurch gekennzeichnet, dass** die Stege (7) an jedem Seitenteil (3) äquidistant angeordnet sind.

8. Behälter nach einem der Ansprüche 6 oder 7, **dadurch gekennzeichnet, dass** sich die Einschübe über nahezu die gesamte Breite der Seitenteile (3) erstrecken.

9. Behälter nach einem der Ansprüche 6 - 8, **dadurch gekennzeichnet, dass** die Zwischenräume zwischen den Stegen (7) am oberen Rand des jeweiligen Seitenteils (3) ausmünden.

10. Behälter nach Anspruch 9, **dadurch gekennzeichnet, dass** die oberen Ränder der Seitenteile (3) mit einer Stoßstange (8) abschließen.

11. Behälter nach Anspruch 10, **dadurch gekennzeichnet, dass** die Stoßstange (8) aus Teflon besteht.

12. Behälter nach einem der Ansprüche 6 - 11, **dadurch gekennzeichnet, dass** die unteren Ränder der Stege (7) eines Seitenteils (3) an ein Stützteil (9) anschließen, wobei jedes Stützteil (9) eine an die Randkontur der Wafer (1) angepasste Auflagefläche (11) aufweist, auf welcher die Wafer (1) abschnittsweise aufliegen.

13. Behälter nach Anspruch 12, **dadurch gekennzeichnet, dass** die Auflagefläche (11) unprofiliert ist.

14. Behälter nach einem der Ansprüche 12 oder 13, **dadurch gekennzeichnet, dass** die Auflagefläche (11) einen kreissegmentförmigen Querschnitt aufweist, wobei der Krümmungsradius des Kreissegments dem Radius eines Wafers (1) entspricht.

15. Behälter nach einem der Ansprüche 12 - 14, **dadurch gekennzeichnet, dass** sich das Stützteil (9) über die gesamte Breite des Seitenteils (3) erstreckt und an diesem befestigt ist.

16. Behälter nach einem der Ansprüche 12 - 15, **dadurch gekennzeichnet, dass** die Stützteile (9) an den beiden Seitenteilen (3) identisch ausgebildet und in Abstand gegenüberliegend angeordnet sind.

17. Behälter nach einem der Ansprüche 12 - 16, **dadurch gekennzeichnet, dass** die Stützteile (9) aus Teflon bestehen.

18. Behälter nach eine der Ansprüche 6 - 17, **dadurch gekennzeichnet, dass** die Seitenteile (3) aus mit Teflon beschichtetem Aluminium bestehen.
